# EUROPÄISCHE PATENTANMELDUNG

(11) **EP 2 320 488 A1**
(43) Veröffentlichungstag der Anmeldung: **11.05.2011**
(21) Anmeldenummer: 09013987.4
(22) Anmeldetag: 07.11.2009
(51) Int. Cl.: H01L 41/09, H02N 1/00, G09B 21/00, F16K 31/02, F04B 43/04

(54) **Elektromechanischer Wandler mit dielektrischem Elastomer**

(71) Anmelder: Bayer MaterialScience AG, 51368 Leverkusen (DE)
(72) Erfinder: Schapeler, Dirk, 50171 Kerpen (DE); Arellano, Ivan, 78432 Konstanz (DE); Clauberg, Karin, 42657 Solingen (DE)

(57) **Zusammenfassung**

Ein elektromechanischer Wandler umfasst eine Schicht (10) eines dielektrischen Elastomers, wobei die Schicht (10) eine Oberseite und eine Unterseite umfasst und wobei auf der Oberseite und der Unterseite der Schicht (10) Elektroden (11, 12) angeordnet sind. Auf der Oberseite der Schicht (10) des dielektrischen Elastomers ist ein erster Magnet (13) angeordnet und auf der Unterseite der Schicht (10) des dielektrischen Elastomers ist ein zweiter Magnet (14) angeordnet. Der erste Magnet (13) ist oberhalb des zweiten Magneten (14) angeordnet. Zwischen dem ersten Magneten (13) und dem zweiten Magneten (14) herrschen magnetische Anziehungskräfte und eine diese Magneten (13, 14) umfassende Anordnung wird erhalten. Der erste Magnet (13) und der zweite Magnet (14) sind relativ zu dem zwischen ihnen befindlichen Abschnitt der Schicht (10) des dielektrischen Elastomers ortsfest angeordnet. Die Schicht (10) des dielektrischen Elastomers ist in Richtung der Flächenausdehnung der Schicht (10) gesehen an mindestens zwei der Anordnung umfassend ersten Magneten (13) und zweiten Magneten (14) gegenüberliegenden Orten fixiert. Unterhalb der Anordnung umfassend ersten Magneten (13) und zweiten Magneten (14) ist ein dritter Magnet (15) angeordnet, welcher auf diese Anordnung eine magnetische Kraft ausübt und wobei die Anordnung umfassend ersten Magneten (13) und zweiten Magneten (14) relativ zum dritten Magneten (15) beweglich ist.

## Beschreibung

Die vorliegende Erfindung betrifft einen elektromechanischen Wandler, umfassend ein dielektrisches Elastomer, auf das über Magnete eine Kraft ausgeübt wird. Sie betrifft weiterhin die Verwendung von erfindungsgemäßen Wandlern in taktilen Anzeigeelementen und zur Steuerung von Fluidströmen.

Der Tastsinn des Menschen setzt sich aus zwei Komponenten zusammen. Diese sind die taktile und die kinästhetische Wahrnehmung. Eine Unterscheidung beider Wahrnehmungen ist für den Ingenieur von großer Bedeutung, wenn es darum geht, die Anforderungen an ein den Tastsinn ansprechendes System zu formulieren. So bedeutet "taktil" die Interaktion des Systems mit der Haut, also die Ertastung von geometrischen Formen. Demgegenüber bezeichnet "kinästhetisch" die aktorischen und sensorischen Eigenschaften von Muskeln und Gelenken und bezieht sich daher auf Kräfte, Momente, Positionen und Winkel.

Für die Entwicklung haptischer Geräte ist das Zusammenspiel von kinästhetischer und taktiler Wahrnehmung von großer Bedeutung, da verlorengegangene Informationen bei Manipulationsaufgaben durch eine künstliche Erzeugung der kinästhetischen und taktilen Rückmeldung zurückgewonnen werden können. So kommen taktile Anzeigeelemente (tactile displays, TD) zum Einsatz, die entweder statische Muster erzeugen, welche vom Benutzer abgetastet werden oder dynamische Muster, die ohne Relativbewegung zwischen Finger und der Oberfläche des taktilen Anzeigegerätes entstehen.

Die Formulierung der Anforderungen an taktile Anzeigeelemente ist von dem Einsatzgebiet und von den Ansprüchen der Umgebung stark abhängig. So können taktile Anzeigeelemente visuelle Informationen in haptische Reize umwandeln, wie es zum Beispiel bei der ertastbaren Brailleschrift der Fall ist. Auch können sie beispielsweise zur Informationsübertragung in Kraftfahrzeugen eingesetzt werden, indem der Reizort, zum Beispiel das linke Bein, dem Fahrer zeigen kann, in welche Richtung er demnächst abbiegen muss. Durch die Wiedergabe einer Frequenz könnte die Entfernung abgetragen werden.

Allgemein besteht ein großes Spektrum für das Einsatzgebiet der haptischen Rückmeldung. So ist es unter anderem möglich, sehr präzise Telemanipulationsaufgaben über größere Distanzen zu lösen, was über die Montage von mikrotechnisch gefertigten Teilen bis hin zu chirurgischen Eingriffen genutzt werden können, ohne größere Verletzungen der Gewebe und Nerven des Patienten hervorzurufen. Ein weiteres Beispiel ist die Raumfahrt, wo mit Hilfe ferngesteuerter Roboter Manipulationsaufgaben außerhalb des Raumfahrzeuges durchgeführt werden können, indem man taktile Anzeigeelemente in Raumanzügen einsetzt.

Für die Umwandlung einer beliebigen Energieform in mechanische Energie existieren unterschiedlichste Lösungsansätze. Aus dem vorherigen Abschnitt ist zu entnehmen, dass die haptische Sinneswahrnehmung auf verschiedene Wege angesprochen werden kann. So kann die Kraft eine konstante statische Größe, aber auch vibrierende Eigenschaften aufweisen. Der Aktor kann entweder über einen einzigen Punkt in Kontakt mit seiner Umgebung kommen oder über eine Kraftverteilung auf einer bestimmten Fläche.

Die Umwandlung in mechanische Energie kann anhand verschiedener Grundprinzipien erfolgen. Beispielsweise können Formgedächtnislegierungen (Shape Memory Alloys) eingesetzt werden. Weitere Prinzipien sind das elektrodynamische Aktorprinzip, das piezoelektrische Aktorprinzip, das elektro- und magnetorheologische Aktorprinzip, das elektrostatische Aktorprinzip und der Einsatz von elektroaktiven Polymeren (EAP). Als elektrische EAP bezeichnet man Werkstoffe, die eine Verformung durch den Elektronentransport erreicht. Zu dieser Gruppe der EAP zählen zum Beispiel die ferroelektrischen oder dielektrischen Polymere.

Eine Konstruktionsvariante von Aktoren mit elektroaktiven Polymeren sind Diaphragma-Aktoren. Von solchen Aktoren spricht man, wenn das EAP sich in einem starren Rahmen befmdet, so dass sich die Folie für einen bestimmten elektrostatischen Druck wölbt, und somit eine lineare Bewegung hervorgerufen wird. Dieses lässt sich mit einer Vorspannung der Folie verbinden.

In diesem Zusammenhang offenbart WO 2008/083325 A1 Wandler auf der Basis von elektroaktiven Polymeren. Diese sind so vorgespannt, dass eine erhöhte Auslenkungskraft und/oder Auslenkungsstrecke erreicht wird. Hierdurch erhöhen sich das Arbeitspotential und die Leistungsausgabe. Die Vorspannung kann weiterhin funktionelle Vorteile in Hinblick auf die Abstimmung der Wandlereigenschaften mit einer vorgegebenen Anwendung wie beispielweise einem normalerweise geschlossenen Ventil liefern. Die verbesserte Vorspannung kann eine Vorspannung mit einer negativen Federkonstante und/oder eine Kombination negativer oder Null-Federkonstanten mit einer Vorspannung mit positiver Federkonstante einsetzen, um den gewünschten Zweck zu erreichen.

In WO 2008/083325 A1 wird beispielsweise eine Wandleranordnung umfassend ein elektroaktives Polymer und ein Vorspannungselement beansprucht, wobei wenigstens ein Vorspannungselement eine Vorspannung mit negativer Federrate auf das elektroaktive Polymermaterial ausübt. Dieses Element kann beispielsweise ein magnetisches Material umfassen. Hierbei kann das Element ein erstes Magnetelement in Kontakt mit dem elektroaktiven Polymermaterial und ein zweites Magnetelement an einer festen Position und beabstandet zum ersten Magnetelement umfassen.

Diese Patentanmeldung behandelt nicht im Detail den Aufbau einer oben beschriebenen Wandleranordnung, sondern erwähnt dieses Prinzip nur kursorisch. Es besteht folglich weiterhin der Bedarf an Konstruktionslösungen für elektromechanische Wandler, bei denen ein elektroaktives Polymermaterial mittels Magnetkraft eine Vorspannung erfährt.

Erfindungsgemäß vorgeschlagen wird daher ein elektromechanischer Wandler, umfassend eine Schicht eines dielektrischen Elastomers, wobei die Schicht eine Oberseite und eine Unterseite umfasst und wobei auf der Oberseite und der Unterseite der Schicht Elektroden angeordnet sind. Auf der Oberseite der Schicht des dielektrischen Elastomers ist ein erster Magnet angeordnet und auf der Unterseite der Schicht des dielektrischen Elastomers ist ein zweiter Magnet angeordnet, wobei der erste Magnet oberhalb des zweiten Magneten angeordnet ist. Zwischen dem ersten Magneten und dem zweiten Magneten herrschen magnetische Anziehungskräfte und es wird eine diese Magneten umfassende Anordnung erhalten.

Der erste Magnet und der zweite Magnet sind relativ zu dem zwischen ihnen befindlichen Abschnitt der Schicht des dielektrischen Elastomers ortsfest angeordnet, wobei die Schicht des dielektrischen Elastomers in Richtung der Flächenausdehnung der Schicht gesehen an mindestens zwei der Anordnung umfassend ersten Magneten und zweiten Magneten gegenüberliegenden Orten fixiert ist.

Unterhalb der Anordnung umfassend ersten Magneten und zweiten Magneten ist ein dritter Magnet angeordnet, welcher auf diese Anordnung eine magnetische Kraft ausübt. Die Anordnung umfassend ersten Magneten und zweiten Magneten ist relativ zum dritten Magneten beweglich.

Ein elektromechanischer Wandler kann beispielsweise ein Aktor, Sensor oder Generator sein. Nachfolgend wird die vorliegende Erfmdung aus Gründen der Übersichtlichkeit in der Regel als Aktor beschrieben werden. Die Erfindung ist jedoch nicht hierauf beschränkt.

Der erfindungsgemäße Wandler umfasst eine Schicht eines dielektrischen Elastomers. Solche Elastomere ändern ihre Form durch das Anlegen eines elektrischen Feldes. Weiterhin verringert sich das Elastizitätsmodul des dielektrischen Elastomers beim Anlegen eines elektrischen Feldes. Bildlich gesprochen wird das Elastomer weicher. Geeignete dielektrische Elastomere sind insbesondere Polyurethanelastomere, weiterhin Silikonelastomere und Acrylatelastomere.

Die Dicke der dielektrischen Elastomerschicht beträgt vorzugsweise ≥20 µm bis ≤150 µm und mehr bevorzugt >65 µm bis ≤75 µm.

Auf der Oberseite und der Unterseite der Schicht des dielektrischen Elastomers sind Elektroden angeordnet. Hierdurch wird ein Plattenkondensator aufgebaut. Dann kommt es beim Anlegen eines elektrischen Feldes zwischen den Elektroden zu einer Dickenkontraktion und Flächenausdehnung der Elastomerschicht. Die Elektroden können unmittelbar an der Schicht des dielektrischen Elastomers angebracht werden. Es ist auch möglich, dass zwischen Elastomer und Elektroden noch weitere Schichten wie beispielsweise Klebstoffschichten zur Verbesserung der Haftung der Elektroden am Elastomer vorgesehen sind. Als Material für die Elektroden kommt beispielsweise aufgetupftes Ruß oder ein entsprechend flexibles elektrisch leitfähiges Polymer in Frage.

Weiterhin befmden sich ein erster Magnet auf der Oberseite und ein zweiter Magnet auf der Unterseite der Schicht des dielektrischen Elastomers. Die Magneten können unmittelbar angrenzend an der Elastomerschicht angeordnet sein oder es können noch weitere Schichten zwischen Magneten und Elastomer vorhanden sein. Hierbei ist der erste Magnet oberhalb des zweiten Magneten und vorzugsweise zentriert über dem zweiten Magneten angeordnet. Die Magnete werden hinsichtlich ihrer magnetischen Pole so positioniert, dass der erste und der zweite Magnet sich gegenseitig anziehen. Hierbei wird eine Anordnung umfassend ersten und zweiten Magneten erhalten, welche vorteilhaft in der Beschreibung von relativen Lagen einzelner Bauelemente im erfindungsgemäßen Wandler herangezogen werden kann.

Vorzugsweise allein durch die Stärke der zwischen dem ersten und dem zweiten Magneten herrschenden Anziehungskraft sind diese Magnete relativ zu dem zwischen ihnen befindlichen Abschnitt der dielektrischen Elastomerschicht ortsfest angeordnet. Dieses ist so zu verstehen, dass diese Magnete zumindest während des normalen Betriebes des erfindungsgemäßen Wandlers nicht auf der dielektrischen Elastomerschicht verschiebbar sind. Erfindungsgemäß eingeschlossen ist natürlich der Fall, dass bei einer Auslenkung der Elastomerschicht die Anordnung umfassend die Magnete dieser Auslenkung folgt.

Die Schicht des dielektrischen Elastomers ist in Richtung ihrer Flächenausdehnung fixiert. Hierdurch wird die Flächenausdehnung beim Anlegen eines elektrischen Feldes eingeschränkt. Die Fixierung geschieht an mindestens zwei Orten, welche der Anordnung umfassend ersten und zweiten Magneten gegenüberliegen. Vorzugsweise sind es mehr als zwei Orte und noch mehr bevorzugt liegt eine umlaufende Fixierung vor. Die Anordnung umfassend ersten und zweiten Magneten kann dann im geometrischen Mittelpunkt der umlaufenden Fixierung positioniert sein.

Weiterhin ist unterhalb der Anordnung umfassend ersten und zweiten Magneten ein dritter Magnet angeordnet, welcher auf diese Anordnung eine magnetische Kraft ausübt. Die magnetische Kraft kann anziehend oder abstoßend sein. Auf diese Weise wird eine Vorspannung der Schicht des dielektrischen Elastomers erreicht. Vorzugsweise liegt der dritte Magnet zentriert zur Anordnung umfassend ersten und zweiten Magneten vor.

Die Magnete im erfindungsgemäßen Wandler können Permanentmagnete sein. Beispiele für geeignete Permanentmagnete sind Neodym-Eisen-Bor-Magnete ("Neodym-Magnete") und Samarium-Kobalt-Magnete. Weiterhin können die Magnete Elektromagnete sein. Es sind auch beliebige Kombinationen von Permanent- und Elektromagneten denkbar. Permanentmagnete sind grundsätzlich günstig, da keine Störungen durch elektrische Ströme zu erwarten sind. Bevorzugt sind aufgrund ihrer geringen Baugröße und des Verzichts auf zusätzliche Kontaktierungen und Ansteuerungsschaltungen die bereits erwähnten Neodym-Magnete.

Erfindungsgemäß ist schließlich vorgesehen, dass die Anordnung umfassend ersten und zweiten Magneten relativ zum dritten Magneten beweglich ist. Dieses bedeutet insbesondere, dass bei einer festen Position des dritten Magneten, beispielsweise in einem Gehäuse, die Anordnung umfassend ersten und zweiten Magneten und mit ihr auch der zwischen erstem und zweitem Magneten befindliche Abschnitt der dielektrischen Elastomerschicht sich bewegen können. Die Richtung der Bewegung ist vor allem die Richtung, der zwischen der Anordnung und dem dritten Magneten herrschenden magnetischen Kraft.

Das Prinzip des erfindungsgemäßen Wandlers soll nun kurz erläutert werden. Eine elektrische Spannung wird an die Elektroden angelegt und somit auch eine durch das dielektrische Elastomer durchreichende elektrische Feld erhalten. Angestrebt werden hohe Spannungen, aber geringe Stromstärken. Geeignete Spannungen können im Bereich von 1000 Volt bis 10000 Volt liegen. Als Folge kommt es zu einer Ausdehnung in Flächenrichtung der dielektrischen Elastomerschicht. Durch die Fixierung der Elastomerschicht resultiert diese Ausdehnung in einer Wölbung der Schicht.

Diese Wölbung erlaubt es der Schicht, sich in Richtung der zwischen dem dritten Magneten und der Anordnung umfassend ersten und zweiten Magneten herrschenden magnetischen Kraft zu bewegen. Gleichzeitig bewegt sich natürlich die Anordnung umfassend ersten und zweiten Magneten, da sie relativ zu dem zwischen dem ersten und dem zweiten Magneten befindlichen Abschnitt der dielektrischen Elastomerschicht ortsfest angeordnet ist. Auf diese Weise kann ein Aktor realisiert werden.

Wird das elektrische Feld abgeschaltet, so kehrt das System in seinen Ursprungszustand zurück. Besonders geeignete Schaltfrequenzen liegen zwischen 100 Hz und 200 Hz. In diesem Frequenzbereich ist die Empfindlichkeit taktiler Rezeptoren beim Menschen besonders hoch.

Aufgrund der durch die Magnete erzeugten Vorspannung der dielektrischen Elastomerschicht lassen sich größere Auslenkungen und höhere Auslenkkräfte erreichen. Der Vorteil der Verwendung der einander anziehenden ersten und zweiten Magneten ist, dass auf diese Weise eine einfache Anbringung an der dielektrischen Elastomerschicht möglich ist. Die Magnete zentrieren sich selbst und auf den oberen, ersten Magneten können weitere Funktionselemente wie Anzeigestifte oder mechanische Kopplungen angebracht werden. Da zwei Magnete verwendet werden, kann auf sie der dritte Magnet schließlich noch eine Kraft ausüben.

Wenn der erfindungsgemäße Wandler mit den Begriffen eines kartesischen Koordinatensystems beschrieben werden soll, dann liegt die dielektrische Elastomerschicht in der xy-Ebene und die Richtung der Auslenkung von erstem und zweitem Magneten ist die z-Richtung.

Vorstehend wurde erläutert, wie ein einzelnes Magnetsystem aus erstem und zweitem Magneten sowie ein hierauf einwirkender dritter Magnet in einem elektromechanischen Wandlersystem eingesetzt wird. Es ist jedoch auch möglich, auf derselben Schicht des dielektrischen Elastomers mehrere solche Systeme einzusetzen.

In einer Ausführungsform des erfindungsgemäßen Wandlers umfasst dieser eine Mehrzahl der Anordnungen umfassend ersten und zweiten Magneten, wobei jede Anordnung mittels Elektroden einzeln ansteuerbar ist. Auf der Oberseite einer Schicht des dielektrischen Elastomers befinden sich mehrere erste Magnete, welche mit sie anziehenden zweiten Magneten auf der Unterseite der Schicht die einzelnen Magnetsysteme bilden. Die Vorspannung durch auf diese Systeme einwirkende dritte Magnete kann durch einen gemeinsamen Magneten, durch mehrere dritte Magnete oder auch durch einen einzelnen dritten Magneten pro Anordnung umfassend ersten und zweiten Magneten erreicht werden.

Es ist weiterhin vorgesehen, dass jede solche Anordnung mittels Elektroden einzeln ansteuerbar ist. Hierunter ist zu verstehen, dass der eine einzelne Anordnung umgebende Bereich der Schicht des dielektrischen Elastomers durch Elektroden mit einem elektrischen Feld beaufschlagbar ist, wobei dieses unabhängig von Bereichen der dielektrischen Elastomerschicht geschieht, welche die anderen Anordnungen umgeben.

Als Beispiel für ein Mehraktorsystem sei ein Vier-Aktor-System genannt. Auf einer einzigen dielektrischen Elastomerschicht sind gleichmäßig verteilt vier erste Magnete auf der Oberseite und vier zweite Magnete auf der Unterseite angebracht. Jeweils ein erster Magnet und ein zweiter Magnet ziehen sich an und sind dadurch bezüglich des zwischen ihnen liegenden Abschnittes der dielektrischen Elastomerschicht fixiert. Unter jeder Anordnung umfassend einen ersten und einen zweiten Magneten ist ortsfest ein dritter Magnet angeordnet, der eine abstoßende magnetische Kraft auf die jeweilige Anordnung ausübt.

Pro Anordnung liegt ein Elektrodenpaar vor, welches an den die Anordnung umgebenden Teil der dielektrischen Elastomerschicht ein elektrisches Feld anlegen kann. Hierbei lässt sich beispielsweise eine Matrixansteuerung einsetzen. Wird nun an ein Elektrodenpaar eine elektrische Spannung angelegt, so kommt es in dem von ihnen beeinflussten Bereich der dielektrischen Elastomerschicht zu einer Dickenkontraktion und zu einer Ausdehnung in Flächenrichtung. Durch die Fixierung der dielektrischen Elastomerschicht insgesamt und durch die nicht vom elektrischen Feld der Elektroden beeinflussten Bereiche der Elastomerschicht wölbt sich die Elastomerschicht lokal. Dieses ermöglicht es dem betreffenden Magnetsystem umfassend ersten und zweiten Magneten, der abstoßenden Kraft des ihnen zugeordneten dritten Magneten auszuweichen und beispielsweise eine Bewegung nach oben auszuführen.

In einer weiteren Ausführungsform des erfindungsgemäßen Wandlers ist die Schicht des dielektrischen Elastomers zwischen einem oberhalb der Schicht angeordneten ersten Ring und einem unterhalb der Schicht angeordneten zweiten Ring fixiert und der erste Ring an seiner Oberseite und der zweite Ring an seiner Unterseite umfassen jeweils übereinander angeordnete Magnete, welche zu dem Magnet des anderen Rings eine Anziehung ausüben. Die Ringe müssen nicht notwendigerweise kreisförmig sein, sondern sie können auch beispielsweise einen elliptischen oder viereckigen Umfang aufweisen. Vielmehr ist der Begriff "Ring" als geschlossene umlaufende Begrenzung zu verstehen.

Sowohl der erste, oberhalb der Elastomerschicht angeordnete Ring als auch der zweite, unterhalb angeordnete Ring weisen Magnete auf. Hierbei weist der erste Ring die Magnete an seiner Oberseite, also der der Elastomerschicht entgegengesetzten Seite, auf. Entsprechend weist der zweite Ring die Magnete auf seiner der Elastomerschicht entgegengesetzten Unterseite auf. Die Magnete des ersten und des zweiten Rings werden so angeordnet, dass sich jeweils ein Magnet des ersten und zweiten Rings anziehen und somit die Ringe an sich zueinander hingezogen werden.

Durch die Verwendung solcher Ringe lässt sich die dielektrische Folie mitsamt der sie kontaktierenden Elektroden fixieren, ohne dass Folie oder Elektroden durchlöchert oder durchbohrt werden müssen.

Die beste Anziehung der Ringe zueinander lässt sich erreichen, wenn die Polung der Magnete an dem jeweiligen Ring alternierend ist. Als Beispiel würde an dem ersten Ring die Abfolge der Polung Nord-Süd-Nord-Süd und an dem zweiten Ring Süd-Nord-Süd-Nord.

Vorteilhafterweise umfassen der erste und der zweite Ring an ihrem äußeren Rand jeweils eine Aussparung. Die Aussparung sollte zumindest an dem der Elastomerschicht zugewandten Teil der Ringe vorhanden sein. Werden die Ringe so angeordnet, dass die Aussparungen übereinander liegen, so können an dieser Stelle die Elastomerschicht und die Elektroden überstehen. Auf diese Weise lassen sich die Elektroden leicht kontaktieren.

In einer weiteren Ausführungsform des erfindungsgemäßen Wandlers wird die Fixierung der Schicht des dielektrischen Elastomers auf ihrer Oberseite und/oder auf ihrer Unterseite durch einen Ring erreicht, wobei der Ring magnetisch ist und zumindest an seiner Oberfläche elektrisch leitfähig ist und wobei der Ring weiterhin eine Elektrode elektrisch kontaktiert. Der Ring oder die Ringe müssen nicht notwendigerweise kreisförmig sein, sondern sie können auch beispielsweise einen elliptischen oder viereckigen Umfang aufweisen. Vielmehr ist der Begriff "Ring" als geschlossene umlaufende Begrenzung zu verstehen.

Dadurch, dass der gesamte Ring magnetisch ist, kommt es zu keinen punktuellen mechanischen Belastungen der Elastomerschicht oder der Elektroden. Ein weiterer Vorteil ist, dass die Kontaktierung der Elektrode einfach über den Ring erfolgen kann. Selbstverständlich kann das Gegenstück zur Fixierung der Elastomerschicht auf der anderen Seite ebenfalls ein solcher magnetischer Ring sein. Dann wird die Polung der beiden Magnete so gewählt, dass sie sich gegenseitig anziehen.

In einer weiteren Ausführungsform des erfindungsgemäßen Wandlers ist die dem ersten Magneten und/oder dem zweiten Magneten zugewandte Fläche des dritten Magneten kleiner ist als die dem dritten Magneten zugewandten Fläche des ersten Magneten und/oder des zweiten Magneten. Im Fall von zylindrischen Permanentmagneten wäre beispielsweise der Durchmesser des dritten Magneten kleiner als der Durchmesser des ersten und/oder des zweiten Magneten. Durch diese Größenverhältnisse wird erreicht, dass die resultierende Fläche des Magnetsystems umfassend ersten und zweiten Magneten größer ist als die resultierende Fläche des dritten Magneten. Hierdurch können störende Kippmomente auf die Anordnung umfassend ersten und zweiten Magneten vermieden werden.

Geeignete Verhältnisse für die resultierende Fläche des Magnetsystems umfassend ersten und zweiten Magneten, die der Fläche des dritten Magneten zugewandt ist, sind insbesondere ≥1,5:1 bis ≤10:1 und vorzugsweise ≥2:1 bis ≤5:1.

In einer weiteren Ausführungsform des erfindungsgemäßen Wandlers ist die dem zweiten Magneten zugewandte Fläche des ersten Magneten größer oder kleiner als die dem ersten Magneten zugewandte Fläche des zweiten Magneten. Im Fall von zylindrischen Permanentmagneten wäre beispielsweise der Durchmesser des ersten Magneten größer als der Durchmesser des zweiten Magneten. Durch diese Größenverhältnisse lässt sich eine Reduzierung der bewegten Masse der Anordnung umfassend ersten und zweiten Magneten erreichen.

Geeignete Verhältnisse für die dem zweiten Magneten zugewandte Fläche des ersten Magneten sind insbesondere ≥1,5:1 bis ≤10:1 und vorzugsweise ≥2:1 bis ≤5:1. Im umgekehrten Fall kann beispielsweise das Verhältnis der dem ersten Magneten zugewandte Fläche des zweiten Magneten insbesondere ≥1,5:1 bis ≤10:1 und vorzugsweise ≥2:1 bis ≤5:1 betragen.

In einer weiteren Ausführungsform des erfindungsgemäßen Wandlers umfasst die Schicht des dielektrischen Elastomers ein Polyurethan mit einem Elastizitätsmodul von ≥0,1 MPa bis ≤1 MPa. Das Elastizitätsmodul kann anhand der Norm DIN 53457 im Zugversuch bestimmt werden und kann auch in einem Bereich von ≥0,2 MPa bis ≤0,9 MPa oder ≥0,3 MPa bis ≤0,8 MPa liegen. Es ist weiterhin bevorzugt, dass das Polyurethan eine dielektrische Konstante von ≥ 2 und insbesondere von ≥ 10 aufweist. Man erhält dann ein weichelastisches Polyurethan mit hoher Durchbruchsfeldstärke und hohem elektrischen Widerstand bei gleichzeitig guten mechanischen Eigenschaften.

In einer weiteren Ausführungsform des erfmdungsgemäßen Wandlers umfasst das Material mindestens einer Elektrode eine Mischung umfassend Ruß und ein polymeres Polyol. Hierdurch können flexible Elektroden erhalten werden. Geeignete Ruße sind beispielsweise Leitruße, wie sie unter dem Namen Ketjenblack® und HiBlack® erhältlich sind. Vorzugsweise liegt der mittlere Durchmesser der Rußpartikel in einem Bereich von ≥10 nm bis ≤50 nm. Besonders bevorzugt ist es, wenn eine Mischung zweier Rußsorten zum Einsatz kommt, wobei eine Rußsorte einen mittleren Partikeldurchmesser von ≥28 nm bis ≤32 nm und eine andere Rußsorte einen mittleren Partikeldurchmesser von ≥ 13 nm bis ≤ 25 nm aufweisen. Diese Rußsorten können im Gewichtsverhältnis von 1:1 gemischt werden.

Ein besonders bevorzugtes Polyol ist insbesondere ein Polyoxypropylenglykol mit einem zahlenmittleren Molekulargewicht von ≥3900 g/mol bis ≤4100 g/mol und einer Hydroxylzahl gemäß DIN 53240 von ≥26 mg KOH/g bis ≤30 mg KOH/g. Das Polyol und der Ruß können zweckmäßigerweise zusammen gemahlen werden, um eine Elektrodenzubereitung zu erhalten. Das Massenverhältnis von Ruß zu Polyol ist vorzugsweise ≥1:10 bis ≤1:20 und mehr bevorzugt ≥1:14 bis ≤1:16. In Versuchen wurde gefunden, dass eine Elektrode mit dem vorstehend als besonders bevorzugt gekennzeichneten Material eine Durchbruchspannung von über 5 kV aufweist.

In einer weiteren Ausführungsform des erfindungsgemäßen Wandlers sind die Elektroden nur an solchen Abschnitten der Schicht des dielektrischen Elastomers angeordnet sind, welche nicht beidseitig von anderen Elementen des Wandlers kontaktiert werden. Beispielsweise ist dann der Bereich der Elastomerschicht, welcher sich zwischen dem ersten und dem zweiten Magneten befmdet, nicht mit Elektroden versehen. Ein anderes Beispiel betrifft den Fall, dass die Elastomerschicht zwischen zwei Ringen fixiert ist. Dann ist der Bereich der Elastomerschicht, der durch die Ringe abgedeckt ist, frei von Elektroden. Der Vorteil einer solchen Anordnung liegt darin, dass die mechanische Belastung einer möglicherweise fragilen Elektrodenschicht verringert wird.

In einer weiteren Ausführungsform des erfindungsgemäßen Wandlers ist in Bewegungsrichtung des ersten Magneten ein Gehäuseteil angeordnet, welches auf der dem ersten Magneten zugewandten Seite eine Vertiefung zur Aufnahme des ersten Magneten umfasst und wobei weiterhin der Durchmesser der Vertiefung mit zunehmender Entfernung vom ersten Magneten kontinuierlich abnimmt. Auf diese Weise lässt sich die Reibung bei der Auslenkung der dielektrischen Elastomerschicht und der damit verbundenen ersten und zweiten Magnete verringern oder vermeiden. Es kommt bei einer Aufwärtsbewegung des ersten Magneten nur zu einem geringen Kontakt zwischen dem Rand des Magneten und dem Rand der Vertiefung. Ein Beispiel für eine solche Vertiefung ist eine kreisförmige Vertiefung, deren Durchmesser mit zunehmender Tiefe abnimmt. Der Durchmesser kann zunächst geringfügig größer sein als der Durchmesser des ersten Magneten, um eine verbesserte Führung zu erreichen. Mit zunehmender Tiefe verengt sich dann der Durchmesser, bis er kleiner als der Durchmesser des ersten Magneten ist. Der Rand der Vertiefung kann hinsichtlich seines Querschnittsprofils beispielsweise gerade oder viertelkreisförmig ausgestaltet sein.

In einer weiteren Ausführungsform des erfindungsgemäßen Wandlers umfasst der erste Magnet einen Anzeigestift und der Anzeigestift ist weiterhin mit einer durch den Anzeigestift hindurch verlaufenden Bohrung versehen. Durch die Auslenkung der dielektrischen Elastomerschicht und der Anordnung umfassend ersten und zweiten Magneten wird auch der Anzeigestift ausgelenkt. Je nach Lage der Bohrung kann nun ein Fluid hindurchfließen oder der Fluss wird abgesperrt. Auf diese Weise kann eine Ventilfunktionalität erreicht werden.

Ein weiterer Gegenstand der vorliegenden Erfindung ist ein taktiles Anzeigeelement, umfassend einen erfindungsgemäßen elektromechanischen Wandler. Insbesondere kann das Anzeigeelement eine Vielzahl einzeln ansteuerbarer erfindungsgemäßer Wandler als Aktoren umfassen. Ein Einsatzgebiet für solche Anzeigeelemente ist beispielsweise die Wiedergabe von Braille-Schrift. Es ist auch vorstellbar, dass erfindungsgemäße taktile Anzeigeelemente in Mobiltelefonen oder als Bedienelemente beispielsweise in Kraftfahrzeugen zum Einsatz kommen, wo die Oberfläche des Anzeigefeldes auf eine Berührung reagiert und so die taktile Rückmeldung je nach Form, Frequenz und Dauer der Vibrationen verschiedene haptische Effekte eines Knopfes simuliert. Der Vorteil ist, dass nicht die vollkommene Aufmerksamkeit des Benutzers in Anspruch genommen wird und somit beim Einsatz in Automobilen oder bei der Bedienung von Maschinen eine erhöhte Sicherheit erreicht werden kann.

Prinzipiell können taktile Anzeigeelemente mit Kraftrückmeldung ebenfalls in sogenannten "virtual reality"-Systemen eingesetzt werden kann, sei es um imaginäre oder reale Umgebungen zu simulieren, bei der Entwicklung von Spielen oder um während der Ausführung von Telemanipulationsaufgaben Objekte zu fühlen oder berühren. So können Vibrationen für die Darstellung von Oberflächentexturen genutzt werden, indem man bei zum Beispiel bei der Nachahmung einer glatten Oberfläche die Rückmeldung der Aktoren mit einer hohen Frequenz ansteuert. Ein weiteres mögliches Einsatzgebiet liegt im medizinischen Bereich und insbesondere als manitaktiles oder podotaktiles Display für sehbehinderte Menschen.

Ein weiterer Gegenstand der vorliegenden Erfindung ist eine Ventileinrichtung für Fluide, umfassend einen erfindungsgemäßen elektromechanischen Wandler. Eine an der Anordnung umfassend ersten und zweiten Magneten angebrachte Sperreinrichtung kann hierbei den Fluss der Fluide steuern. Das Ventil kann so eingerichtet sein, dass sich aufgrund der Vorspannung der dielektrischen Elastomerfolie eine Sicherheitsfunktion ergibt. Hierbei steht das Ventil bei Ausfall der Elektrodensteuerspannung in der für den speziellen Fall jeweils sichereren Stellung. Ein Kühlmittelventil könnte beispielsweise in der geöffneten Stellung und ein Treibstoffventil in einer geschlossenen Stellung verbleiben.

Ein weiterer Gegenstand der vorliegenden Erfindung ist eine Fördervorrichtung für Fluide, umfassend einen erfindungsgemäßen elektromechanischen Wandler. Ein erfindungsgemäßer Aktor kann beispielsweise als Pumpe eingesetzt werden. Es ist auch denkbar, dass eine Anordnung umfassend erfindungsgemäße Wandler als Ventile und andere erfindungsgemäße Aktoren als Pumpen aufgebaut werden kann.

Selbstverständlich ist die Verwendung eines erfindungsgemäßen elektromechanischen Wandlers für taktile Anzeigeelemente, Ventileinrichtungen für Fluide und Fördervorrichtungen für Fluide ebenfalls im Rahmen der vorliegenden Erfindung vorgesehen.

Die vorliegende Erfindung wird anhand der nachfolgenden Zeichnungen weiter erläutert, ohne hierauf beschränkt zu sein. Es zeigen:
- FIG. 1: einen erfindungsgemäßen Wandler
- FIG. 2: die Fixierung der EAP-Folie zwischen zwei Ringen
- FIG.: 3 eine Explosionszeichnung eines erfindungsgemäßen Wandlers
- FIG. 4: einen weiteren erfindungsgemäßen Wandler
- FIG.: 5 einen weiteren erfindungsgemäßen Wandler
- FIG. 6: einen weiteren erfindungsgemäßen Wandler
- FIG. 7 a-c: eine Weiterentwicklung eines Rings zur Fixierung der Elastomerschicht

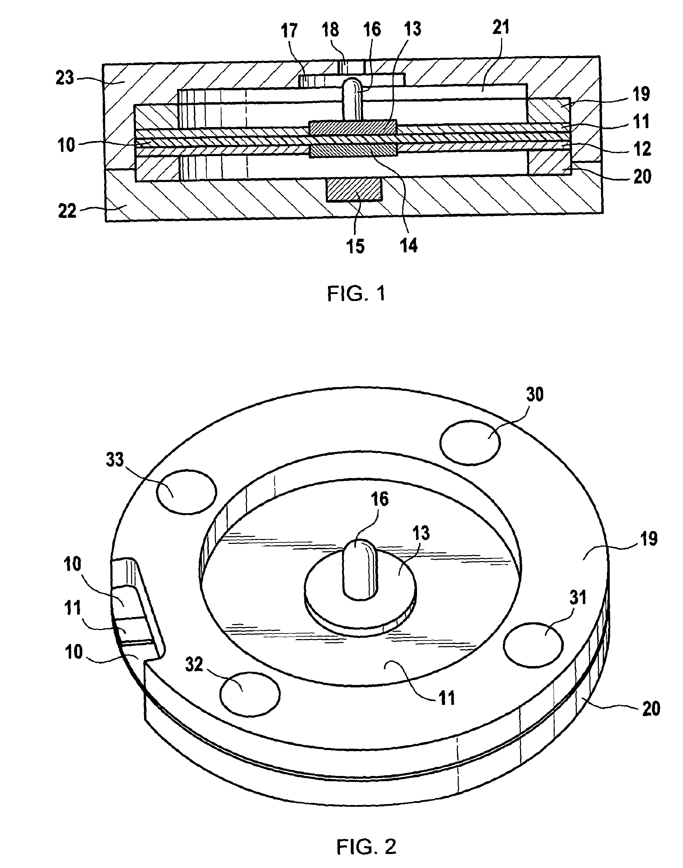

FIG. 1 zeigt einen erfmdungsgemäßen Wandler, wie er vorzugsweise als taktiles Anzeigeelement eingesetzt werden kann. Die Schicht 10 eines dielektrischen Elastomers weist auf ihrer Oberseite eine Elektrode 11 und auf ihrer Unterseite eine Elektrode 12 auf. Weiterhin sind auf der Schicht 10 der erste Magnet 13 und unter der Schicht 10 der zweite Magnet 14 angeordnet. Die Magnete 13 und 14 ziehen sich dabei gegenseitig an. Auf diese Weise sind sie auf der Schicht 10 fixiert. Weiterhin befindet sich auf dem ersten Magneten 13 ein Anzeigestift 16.

Die Elektroden 11, 12 bedecken nicht vollständig die Elastomerschicht 10. Dort, wo Magnete 13 und 14 auf der Elastomerschicht 10 lokalisiert sind, befindet sich keine Elektrode 11, 12. Die Elastomerschicht 10 mitsamt der Elektroden 11, 12 wird an ihren Rändern dadurch fixiert, dass sie zwischen einem oberen Ring 19 und einem unteren Ring 20 eingeklemmt ist. Hierdurch wird zu allen Seiten hin die Ausdehnung in Flächenrichtung eingeschränkt.

Nach Außen wird der erfmdungsgemäße Wandler durch ein Gehäuse mit dem ersten, unteren Gehäuseteil 22 und dem zweiten, oberen Gehäuseteil 23 begrenzt. In einer Vertiefung des unteren Gehäuseteils 22 ist der dritte Magnet 15 ortsfest angeordnet. Die Magnete 13, 14 und 15 sind vertikal zueinander zentriert. Weiterhin ist der Durchmesser des ersten und zweiten Magneten 13, 14 größer als der Durchmesser des dritten Magneten 15. Der dritte Magnet 15 ist hinsichtlich seiner Pole so ausgerichtet, dass er eine abstoßende Wirkung auf das magnetische System mit erstem und zweitem Magneten 13, 14 ausübt.

Im oberen Gehäuseteil 23 befinden sich auf der Seite, welche dem ersten Magneten 13 zugewandt ist, eine Vertiefung 17 und eine Bohrung 18. Die Vertiefung 17 dient zur Aufnahme des ersten Magneten 13 bei einer vertikalen Aufwärtsbewegung und ist für diesen Zweck dimensioniert. Der Anzeigestift 16 ragt nach einer vertikalen Aufwärtsbewegung durch die Bohrung 18 durch und kann ertastet werden.

Wird zwischen der oberen Elektrode 11 und der unteren Elektrode 12 eine elektrische Spannung angelegt, reagiert darauf die dielektrische Elastomerschicht mit einer Kontraktion der Dicke und einer Ausdehnung in Flächenrichtung. Da die Schicht 10 an den Rändern zwischen Ringen 19 und 20 eingeklemmt ist, kommt es zu einer Stauchung der Schicht.

Durch die mechanische Kopplung der Schicht 10 mit den Magneten 13, 14 folgt die Schicht 10 der Bewegung von Magneten 13, 14 nach oben, welche durch die abstoßende magnetische Kraft aufgrund des dritten Magneten 15 hervorgerufen wird. Der Hohlraum 21 unter dem oberen Deckel 23 ist so dimensioniert, dass eine maximale Auslenkung der Schicht 10 und der mit ihr verbundenen Magnete 13, 14 und Stift 16 erreicht wird.

In der Aufwärtsbewegung durchtritt Stift 16 die Bohrung 18. Diese Bohrung wirkt auch als Führung und kann zu einer Stabilisierung des magnetischen Systems gegenüber Kippmomenten führen. Ebenso verhält es sich mit Vertiefung 17, sobald sie den ersten Magneten 13 aufgenommen hat. Besteht das elektrische Feld durch die Schicht 10 hindurch nicht mehr, kontrahiert die Schicht 10 in Flächenrichtung und die Anordnung mit Magneten 13 und 14 sowie Stift 16 kehrt in ihre Ausgangsstellung zurück.

FIG. 2 zeigt ein Detail eines erfindungsgemäßen Wandlers. Zwischen oberem Ring 19 und unterem Ring 20 ist die dielektrische Elastomerschicht 10 samt Elektroden fixiert. Hier zu sehen ist die obere Elektrode 11. Zentral angeordnet auf der Schicht 10 ist der obere Magnet 13 samt Anzeigestift 16. Der obere Ring 19 und der untere Ring 20 weisen jeweils Aussparungen auf, welche die Elastomerschicht 10 und die darauf liegenden Elektrode freigeben. Auf diese Weise lässt sich mit wenig Aufwand eine Kontaktierung der Elektroden der fixierten Elastomerschicht 10 erreichen.

Auf der Oberseite des oberen Rings 19 sind Magnete 30, 31, 32, 33 in Vertiefungen ortsfest angebracht. Aufgrund der Perspektive der Schrägansicht nicht sichtbar dargestellt befinden sich auf der Unterseite des unteren Rings 20 ebenfalls Magnete. Diese sind vertikal zentriert über den jeweiligen Magneten 30, 31, 32, 33 angeordnet. Die Magnete der beiden Ringe 19, 20 üben zu ihrem Gegenstück des jeweils anderen Ringes eine Anziehung aus. Hieraus resultiert die Kraft, die die beiden Ringe 19, 20 aufeinander hält und so die dielektrische Schicht 10 fixiert.

Wie bereits erwähnt ist es vorteilhaft, wenn eine alternierende Abfolge der Polung der Magnete im jeweiligen Ring vorliegt. So könnte die zur Schicht 10 gewandte Seite des Magneten 30 beispielweise ein magnetischer Nordpol sein, die entsprechende Seite des benachbarten Magneten 31 ein magnetischer Südpol und so weiter. Zur Kontaktierung der Elektroden weisen die beiden Ringe 19, 20 eine Aussparung auf, aus der die Schicht 10 und die Elektroden heraustreten.

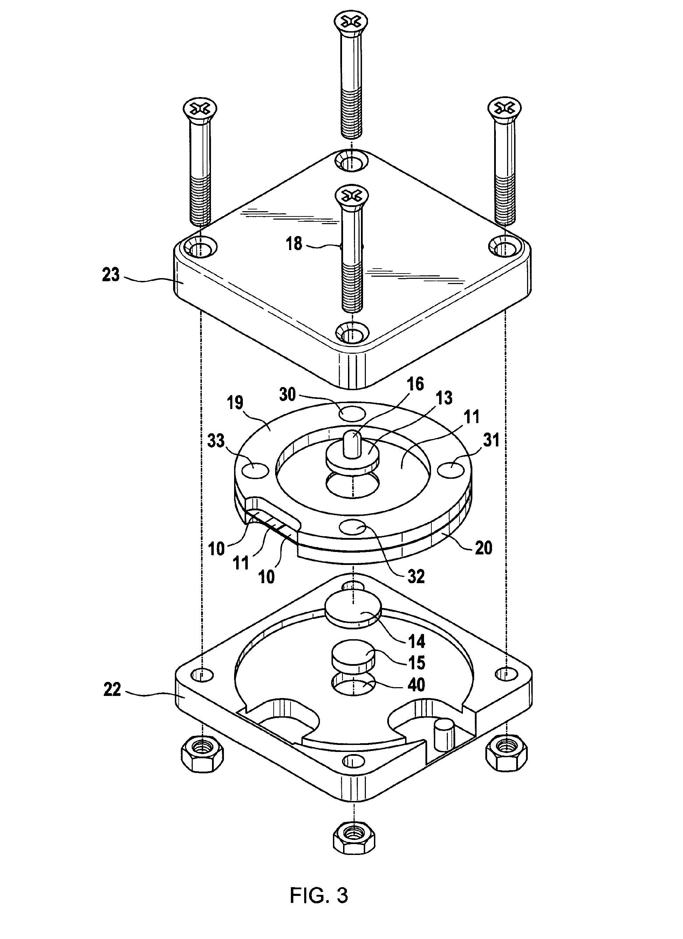

FIG. 3 zeigt eine Explosionszeichnung eines erfindungsgemäßen Wandlers. Die Bauteile und Bezugszeichen wurden bereits vorstehend erläutert. Der untere Gehäusedeckel 22 und der obere Gehäusedeckel 23 werden miteinander durch Schrauben und Muttern verbunden. Über diese Gehäusedeckel lässt sich zusätzlicher Druck auf die Ringe 19, 20 ausüben, so dass die dielektrische Elastomerschicht 10 noch stärker fixiert wird. Im unteren Gehäusedeckel 22 dient Vertiefung 40 zur ortsfesten Aufnahme des dritten Magneten 15. Weitere, nicht mit Bezugszeichen versehene Aussparungen im unteren Deckel 22 schaffen Platz für Kabel zur Kontaktierung der Elektroden auf der Schicht 10.

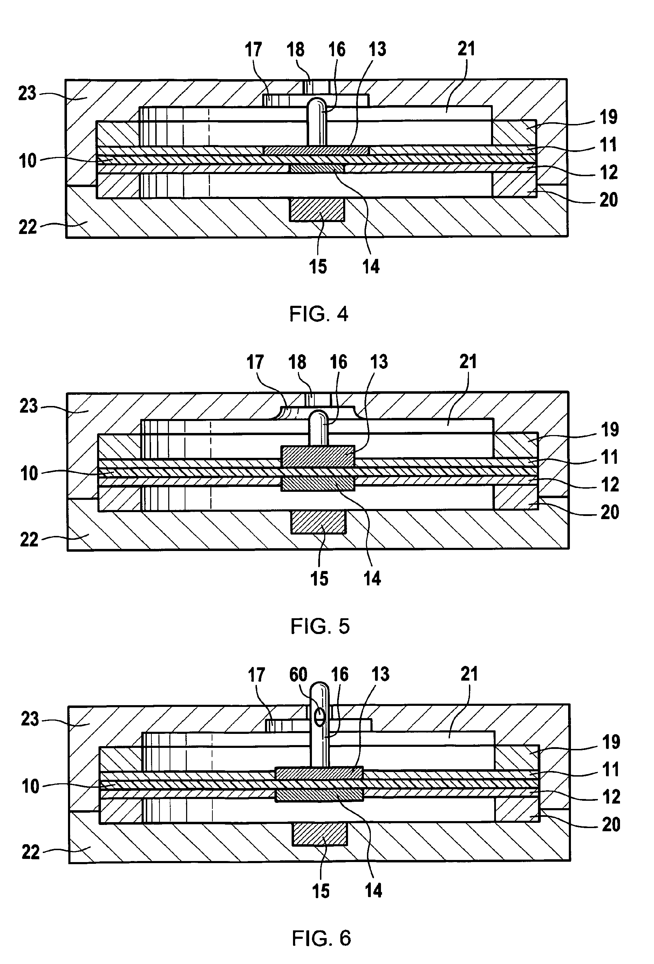

Der in FIG. 4 gezeigte erfindungsgemäße Wandler entspricht in weiten Teilen dem Wandler aus FIG. 1. Der Unterschied liegt darin, dass der obere, erste Magnet 13 breiter und flacher ausgeführt ist als sein Gegenstück im Wandler aus FIG. 1. Ebenfalls ist der untere, zweite Magnet 14 schmaler und flacher ausgeführt. Durch diese Konstruktion lässt sich die während der Auslenkung der Schicht 10 bewegte Masse verringern. Gleichzeitig weist die Anordnung umfassend ersten Magneten 13 und zweiten Magneten 14 immer noch eine größere wirksame Fläche als der dritte Magnet 15 auf, so dass das System gegen Kippmomente stabilisiert ist.

FIG. 5 zeigt eine Möglichkeit, um unerwünschte Reibung bei der Auslenkung der Schicht 10 und der damit verbundenen Magnete 13, 14 zu verringern oder zu vermeiden. Der hier gezeigte erfindungsgemäße Wandler entspricht in weiten Teilen dem Wandler aus FIG. 1. Ein Unterschied ist, dass der Rand der zur Aufnahme des ersten Magneten 13 vorgesehenen Vertiefung 17 abgerundet ist. Hierdurch kommt es bei einer Aufwärtsbewegung des Magneten 13 nur zu einem geringen Kontakt zwischen dem Rand des Magneten 13 und dem Rand der Vertiefung 17.

Die Dicke des Magneten wurde so angepasst, dass bei einer Auslenkung der Schicht 10 es zu dem gewünschten Ausmaß des Kontaktes kommt. Ein weiterer Vorteil ist, dass durch die Abrundung des Randes der Vertiefung 17 auch eine Führung des Magneten 13 dergestalt erreicht wird, dass eine seitliche Verkippung oder Verkantung wieder in die Horizontale ausgeglichen werden kann.

Ein möglicher Einsatz eines erfindungsgemäßen Wandlers zur Steuerung von Fluiden ist in FIG. 6 dargestellt. Der hier gezeigte Wandler entspricht in weiten Teilen dem Wandler aus FIG. 1. Ein Unterschied ist, dass im Anzeigestift 16 eine Bohrung 60 vorgesehen ist, durch die Fluide strömen können. Hierdurch wird ein Ventil erhalten, welches je nach Auslenkung der dielektrischen Elastomerschicht 10 und des letztendlich damit gekoppelten Anzeigestifts 16 Fluide durch Bohrung 16 strömen lässt oder die Strömung sperrt.

Die Lage der Bohrung auf dem Anzeigestift 16 ist so gewählt, dass in der Ruhestellung der Schicht 10, bei nicht angelegtem elektrischem Feld, der Strömungsweg verschlossen ist. Dieses kann als Sicherheitseinrichtung dienen, wenn bei Stromausfall die Fluidströmung unterbrochen werden soll.

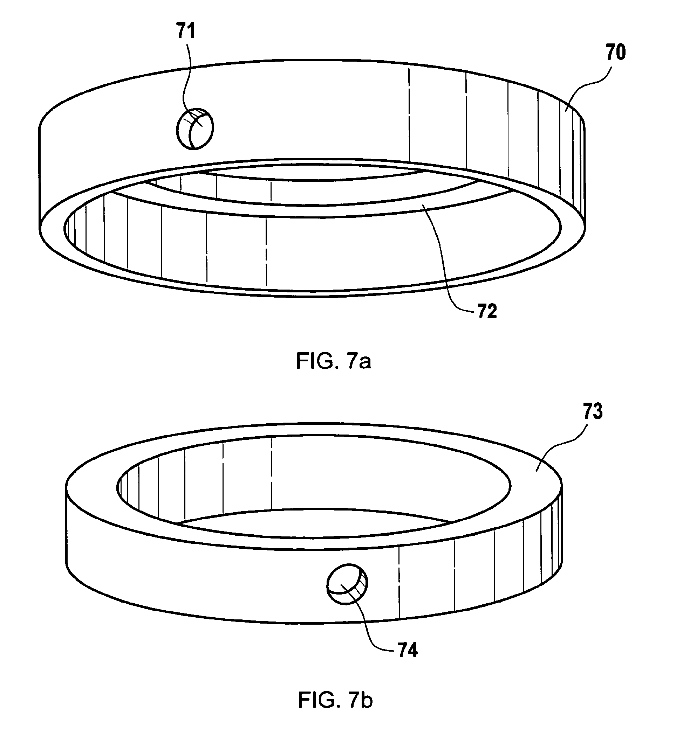

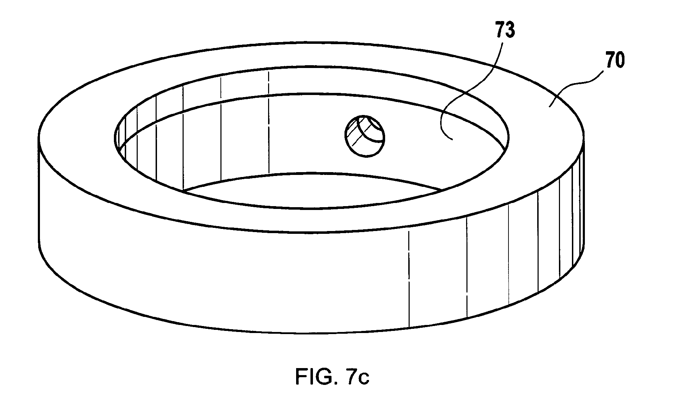

FIG. 7 a-c zeigen eine Weiterentwicklung eines Rings zur Fixierung der Elastomerschicht. Der in FIG. 7a gezeigte Ring 70 ist ein Kunststoffring und dient zur elektrischen Isolierung. In diesem Ring 70 ist eine Bohrung 71 angebracht. Auf der Innenseite des Rings 70 ist eine umlaufende Auskragung 72 vorgesehen, welche als Widerlager zur Aufnahme eines inneren Rings dient.

Dieser innere Ring 73 ist in FIG. 7b dargestellt. Hierbei handelt es sich um einen Permanentmagneten mit elektrisch leitfähiger Oberfläche. Der innere Ring 73 weist ebenfalls eine Bohrung 74 auf.

FIG. 7c zeigt, wie der innere Ring 73 in den Kunststoffring 70 eingesetzt ist. Die Bohrungen 71, 74 liegen übereinander, so dass beispielsweise elektrische Leitungen durch die Ringanordnung geführt werden können. Die hier gezeigte Ringanordnung kann beispielsweise einen oder beide der Ringe 19, 20 in dem in FIG. 2 gezeigten Bauteil ersetzten. Der zugängliche Teil des inneren Ringes 73 kann dann eine Elektrode kontaktieren.

## Patentansprüche

1. Elektromechanischer Wandler, umfassend eine Schicht (10) eines dielektrischen Elastomers, wobei die Schicht (10) eine Oberseite und eine Unterseite umfasst und wobei auf der Oberseite und der Unterseite der Schicht (10) Elektroden (11, 12) angeordnet sind,
**dadurch gekennzeichnet, dass**
auf der Oberseite der Schicht (10) des dielektrischen Elastomers ein erster Magnet (13) angeordnet ist und
auf der Unterseite der Schicht (10) des dielektrischen Elastomers ein zweiter Magnet (14) angeordnet ist,
wobei der erste Magnet (13) oberhalb des zweiten Magneten (14) angeordnet ist,
wobei zwischen dem ersten Magneten (13) und dem zweiten Magneten (14) magnetische Anziehungskräfte herrschen und eine diese Magneten (13, 14) umfassende Anordnung erhalten wird,
wobei der erste Magnet (13) und der zweite Magnet (14) relativ zu dem zwischen ihnen befmdlichen Abschnitt der Schicht (10) des dielektrischen Elastomers ortsfest angeordnet sind,
wobei die Schicht (10) des dielektrischen Elastomers in Richtung der Flächenausdehnung der Schicht (10) gesehen an mindestens zwei der Anordnung umfassend ersten Magneten (13) und zweiten Magneten (14) gegenüberliegenden Orten fixiert ist und
unterhalb der Anordnung umfassend ersten Magneten (13) und zweiten Magneten (14) ein dritter Magnet (15) angeordnet ist, welcher auf diese Anordnung eine magnetische Kraft ausübt und wobei
die Anordnung umfassend ersten Magneten (13) und zweiten Magneten (14) relativ zum dritten Magneten (15) beweglich ist.

2. Elektromechanischer Wandler gemäß Anspruch 1, umfassend eine Mehrzahl der Anordnungen umfassend ersten (13) und zweiten (14) Magneten, wobei jede Anordnung mittels Elektroden (11, 12) einzeln ansteuerbar ist.

3. Elektromechanischer Wandler gemäß Anspruch 1, wobei die Schicht (10) des dielektrischen Elastomers zwischen einem oberhalb der Schicht (10) angeordneten ersten Ring (19) und einem unterhalb der Schicht (10) angeordneten zweiten Ring (20) fixiert ist und wobei der erste Ring (19) an seiner Oberseite und der zweite Ring (20) an seiner Unterseite jeweils übereinander angeordnete Magnete (30, 31, 32, 33) umfassen, welche zu dem Magnet des anderen Rings eine Anziehung ausüben.

4. Elektromechanischer Wandler gemäß Anspruch 1, wobei die Fixierung der Schicht (10) des dielektrischen Elastomers auf ihrer Oberseite und/oder auf ihrer Unterseite durch einen Ring (73) erreicht wird, wobei der Ring magnetisch ist und zumindest an seiner Oberfläche elektrisch leitfähig ist und wobei der Ring weiterhin eine Elektrode (11, 12) elektrisch kontaktiert.

5. Elektromechanischer Wandler gemäß Anspruch 1, wobei die dem ersten Magneten (13) und/oder dem zweiten Magneten (14) zugewandte Fläche des dritten Magneten (15) kleiner ist als die dem dritten Magneten (15) zugewandten Fläche des ersten Magneten (13) und/oder des zweiten Magneten (14).

6. Elektromechanischer Wandler gemäß Anspruch 1, wobei die dem zweiten Magneten (14) zugewandte Fläche des ersten Magneten (13) größer oder kleiner ist als die dem ersten Magneten (13) zugewandte Fläche des zweiten Magneten (14).

7. Elektromechanischer Wandler gemäß Anspruch 1, wobei die Schicht (10) des dielektrischen Elastomers ein Polyurethan mit einem Elastizitätsmodul von ≥0,1 MPa bis ≤1 MPa umfasst.

8. Elektromechanischer Wandler gemäß Anspruch 1, wobei das Material mindestens einer Elektrode (11, 12) eine Mischung umfassend Ruß und ein polymeres Polyol umfasst.

9. Elektromechanischer Wandler gemäß Anspruch 1, wobei die Elektroden (11, 12) nur an solchen Abschnitten der Schicht (10) des dielektrischen Elastomers angeordnet sind, welche nicht beidseitig von anderen Elementen des Wandlers kontaktiert werden.

10. Elektromechanischer Wandler gemäß Anspruch 1, wobei in Bewegungsrichtung des ersten Magneten (13) ein Gehäuseteil (23) angeordnet ist, welches auf der dem ersten Magneten (13) zugewandten Seite eine Vertiefung (17) zur Aufnahme des ersten Magneten (13) umfasst und wobei weiterhin der Durchmesser der Vertiefung mit zunehmender Entfernung vom ersten Magneten (13) kontinuierlich abnimmt.

11. Elektromechanischer Wandler gemäß Anspruch 1, wobei der erste Magnet (13) einen Anzeigestift (16) umfasst und wobei weiterhin der Anzeigestift (16) mit einer durch den Anzeigestift (16) hindurch verlaufenden Bohrung (60) versehen ist.

12. Taktiles Anzeigeelement, umfassend einen elektromechanischen Wandler gemäß Anspruch 1.

13. Ventileinrichtung für Fluide, umfassend einen elektromechanischen Wandler gemäß Anspruch 1.

14. Fördervorrichtung für Fluide, umfassend einen elektromechanischen Wandler gemäß Anspruch 1.
